# EUROPEAN PATENT SPECIFICATION

(11) **EP 0 439 103 B1**
(45) Date of publication and mention of the grant of the patent: **05.04.1995**
(21) Application number: 91100709.4
(22) Date of filing: 21.01.1991
(51) Int. Cl.: H01L 39/14

(54) **Ferromagnetic la-ba-cu-o compound and ferromagnetic device containing same**
Ferromagnetische La-Ba-Cu-O-Verbindungen und ferromagnetische Einrichtung davon
Composition ferromagnétique La-Ba-Cu-O et dispositif ferromagnétique comprenant cette composition

(30) Priority: 23.01.1990 JP 14227/90
(43) Date of publication of application: 31.07.1991
(73) Proprietor: NGK Spark Plug Co. Ltd., City of Nagoya Aichi Prefecture (JP); INTERNATIONAL SUPERCONDUCTIVITY TECHNOLOGY CENTER, Tokyo (JP)
(72) Inventor: Mizuno, Fumio, c/o Nagoya Division, Int., Atsuta-ku, Nagoya-shi, Aichi (JP); Masuda, Hirotake, c/o Nagoya Division, Int., Atsuta-ku, Nagoya-shi, Aichi (JP); Miyajima, Masamichi, c/o Nagoya Division, Int., Atsuta-ku, Nagoya-shi, Aichi (JP); Hirabayashi, Izumi, c/o Nagoya Division, Int., Atsuta-ku, Nagoya-shi, Aichi (JP)
(74) Representative: Grünecker, Kinkeldey, Stockmair & Schwanhäusser Anwaltssozietät

(56) References cited:
- EP-A- 0 372 951
- SCIENCE, vol. 240, 22nd April 1988, pages 495-497, Washington, US; M.A.SUBRAMANIAN et al.: "Superconducting and magnetic behavior in La2-xNaxCuO4"
- NATURE, vol. 345, no. 6278, 28th June 1990, pages 788-789, Basingstoke, GB; F.MIZUNO et al.: "Low-temperature ferromagnetism in La4Ba2Cu2010"

## Description

### FIELD OF THE INVENTION

This invention relates to an La-Ba-Cu-O compound which has for the first time been found to exhibit ferromagnetism at low temperatures. Particularly, the present invention relates to a novel low-temperature ferromagnetic compound and a ferromagnetic device.

Ferromagnetic compounds of La-Ba-Cu-O according to the present invention combined with superconductors having the La-Ba-Cu-O compounds are used in the fields of millimetric wave and submillimetric wave heterodyne mixers, etc. The combination is a tunnel device wherein the ferromagnetic substance serves as a barrier, that is, a device using only quasi-particle tunneling current. The combination is applied to super low noise type quasi-particle microwave mixers which solve the problem of noise caused by Josephson current. Further, they are used in devices in which the ferromagnetic substances are utilized as paramagnetic substances at their transition temperatures or higher.

### BACKGROUND OF THE INVENTION

Many oxide type superconductive materials having a very high critical temperature at which the transition from a normal conductive state to a superconductive state occurs, such as LaBa₂Cu₃O_{7-y} compounds, have been developed in recent years. Examples of these compounds can be found in JP-A-63-230565 (the term "JP-A" as used herein means an "unexamined published Japanese patent application") and JP-A-63-222067.

Further, K₂CuF₄ compounds are known as copper compounds which exhibit ferromagnetism [K. Hirakawa and H. Ikeda, Phys. Rev. Lett., 33, 374 (1974)].

Though the aforesaid K₂CuF₄ compounds exhibit ferromagnetism, the compounds are not oxides, but rather fluorine compounds. Hence, these compounds are not considered to be ceramics having a practical use.

The crystal structures of La₄₋₂ₓBa₂₊₂ₓCu₂₋ₓO₁₀₋₂ₓ compounds wherein 0.15≦x≦0.25 have been disclosed by X-ray analysis (J. Solid State Chemistry, 39, 161-167, 1981, C. MICHEL et al.). However, only the outline of the crystal structures is disclosed by X-ray diffraction, and the details of oxygen deficiency positions, other detailed structures, physical properties, etc. are not described at all. Particularly, the reference does not mention that the compounds exhibit ferromagnetism, particularly at super low temperature of 10K or below. In addition, the composition range disclosed in this reference is limited to the range of only 0.15≦x≦0.25.

### SUMMARY OF THE INVENTION

An object of the present invention is to provide La-Ba-Cu-O compounds which have ferromagnetism at low temperatures.

Another object of the present invention is to provide a ferromagnetic device which utilizes a La-Ba-Cu-O compounds.

Other objects and effects of the present invention will become apparent from the following descriptions.

The present invention provides a millimetric wave heterodyne mixer which comprises a La-Ba-Cu-O compound which has a composition of La₄₋₂ₓBa₂₊₂ₓCu₂₋ₓO₁₀₋₂ₓ (wherein 0≦x≦0.25) and which exhibits ferromagnetism at low temperatures.

Further, the present invention provides a novel ferromagnetic La-Ba-Cu-O compound which has a composition of La₄₋₂ₓBa₂₊₂ₓCu₂₋ₓO₁₀₋₂ₓ (wherein 0≦x<0.15) and which exhibits ferromagnetism at low temperatures.

### BRIEF DESCRIPTION OF THE DRAWINGS

Fig. 1 is a graph showing a relationship between temperature and magnetic susceptibility of La₄₋₂ₓBa₂₊₂ₓCu₂₋ₓO₁₀₋₂ₓ compound (x=0).

Fig. 2 is a graph showing a relationship between external magnetic field and magnetization in the compound shown in Fig. 1.

Fig. 3 is a graph showing X-ray diffraction results of the compound shown in Fig. 1.

Fig. 4 is a graph showing a relationship between temperature and magnetic susceptibility of La₄₋₂ₓBa₂₊₂ₓCu₂₋ₓO₁₀₋₂ₓ compound (x=0.25).

Fig. 5 is a graph showing X-ray diffraction results of the compound shown in Fig. 4.

Fig. 6 is a graph illustrating heating conditions in Examples.

Fig. 7 is a graph showing a relationship between temperature and magnetic susceptibility of LaBa₂Cu₃O_{7-y} compound of Japanese Patent Application No. 1-312624.

Fig. 8 is a graph showing X-ray diffraction results of the compound showing in (B) of Fig. 7.

### DETAILED DESCRIPTION OF THE INVENTION

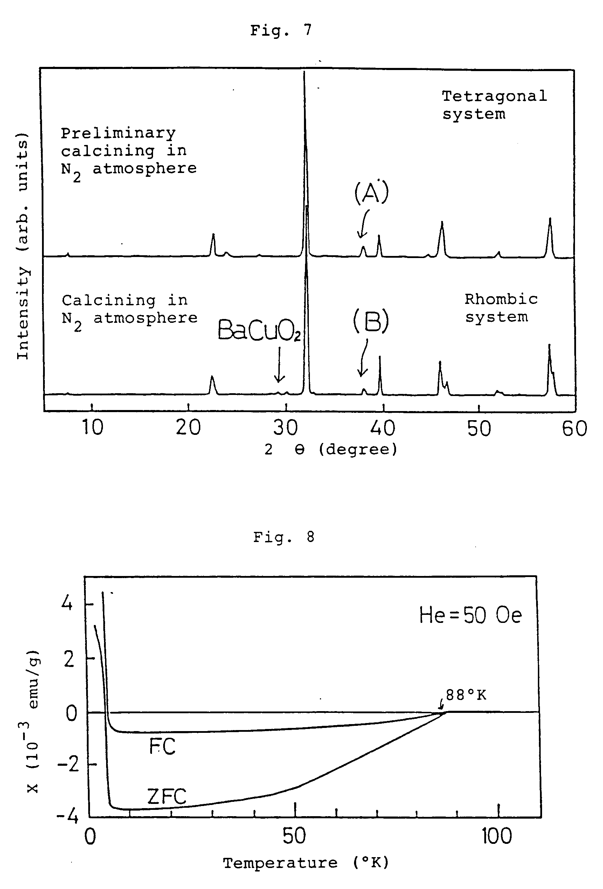

The present inventors have conducted intensive studies on LaBa₂Cu₃O_{7-y} superconductors and found that compounds having a composition of LaBa₂Cu₃O_{7-y} (wherein y is a number from 0.2 to 0.9), calcined in a reduction atmosphere, have ferromagnetism/superconductivity depending on compositions. A patent application [now numbered as Japanese Patent Application No. 1-312624 (hereinafter referred to as "prior application")] was filed on the basis of the above-mentioned finding. It was recognized that compounds in which y is 0.45 to 0.6, prepared under predetermined conditions, exhibited ferromagnetism and superconductivity. The compounds had such a crystal form that preliminary calcined powder ((A) in Fig. 7) had a single phase tetragonal system and the sintered product ((B) in Fig. 7) thereof had a nearly single phase rhombic system, though the sintered product contained some quantity of BaCuO₂ as shown in the X-ray diffraction pattern of Fig. 7. Fluorescent X-ray measurement showed that the amount of magnetic impurities in starting materials used for the preparation of the sample was not more than 100 ppm. Further, X-ray diffraction showed that the aforesaid BaCuO₂ had paramagnetism.

According to the temperature dependence of magnetic susceptibility shown in Fig. 8, the critical transition temperature (Tc) of said sintered product is 88K. When the temperature is lowered below Tc, the sintered product begins to exhibit superconductivity. However, when the temperature is further lowered, magnetic susceptibility rises suddenly at about 6K, positive exhalation is caused and the sintered product exhibits ferromagnetic behavior at a temperature of below about 6K. Assuming that the magnetic character is attributable to Cu ion, effective magnetic moment in the paramagnetic region of the compound is 0.49 »B/Cu and saturation magnetic moment determined from hysteresis is 0.11 »B/cu. Further, the specific heat curve showed a peak at 5K as shown in Fig. 8 and hence the existence of ferromagnetism was suggested.

On the other hand, it is reported that La₄Ba₄Cu₅O₁₃, La₃Ba₃Cu₆O₁₄, and La₄Ba₂Cu₂O₁₀ are formed in the La-Ba-Cu-O system, depending on calcining conditions, because La and Ba easily form a solid solution (J. Solid State Chemistry, 37, 151 (1981), L. Br-Rahko et al., J. Solid State Chemistry, 39, 164 (1981), C. Michel et al. and J. Solid State Chemistry, 68, 143 (1987), C. Michel et al.). Further, it is reported that when calcined in a He atmosphere, LaBa₂Cu₃O_{7-y} is decomposed into La₄₋₂ₓBa₂₊₂ₓCu₂₋ₓO₁₀₋₂ₓ and BaCu_{2.5}Oₓ (J. Mater. Res., 4, 1111 (1989), Ghandehari et al.).

Accordingly, there is a possibility that a very small amount of the above different phases of La-Ba-Cu-O is contained in the aforesaid LaBa₂Cu₃O_{7-y} compound, though such different phases cannot be confirmed by X-ray diffraction pattern. The confirmation of the different phases in the micro-region and the identification of the ratio of elements in the different phases were made by using Scanning Electron Microscope (SEM) and Electron Probe X-ray Microanalysis (EPMA). As a result, it was found that BaCuO₂ and La₄Ba₂Cu₂O₁₀ phases exist in addition to LaBa₂Cu₃O_{7-y}.

In order to examine which phase exhibited ferromagnetism, a sample was prepared under the same manufacturing conditions as those of the aforesaid LaBa₂Cu₃O_{7-y} compounds that exhibiting unusual magnetic properties, and the magnetic susceptibility thereof was examined. It was found that only La₄Ba₂Cu₂O₁₀ exhibits ferromagnetism. The present invention has been accomplished on the basis of this finding.

The first embodiment of the present invention involves compounds which have a composition of La₄₋₂ₓBa₂₊₂ₓCu₂₋ₓO₁₀₋₂ₓ (wherein 0≦x<0.15) and are novel low-temperature ferromagnetic compounds.

The second embodiment of the present invention relates to a ferromagnetic device which comprises compounds which have a composition of La₄₋₂ₓBa₂₊₂ₓCu₂₋ₓO₁₀₋₂ₓ (wherein 0≦x≦0.25) and are low-temperature ferromagnetic compounds.

The present invention is now illustrated in greater detail by reference to the following example which, however, is not to be construed as limiting the invention in any way.

### EXAMPLE

### (1) Examination of ferromagnetic compounds (impurities) in the prepared LaBa₂Cu₃O_{7-y} compound

Further studies have been made on the novel LaBa₂Cu₃O_{7-y} compound exhibiting both superconductivity and ferromagnetism as mentioned in the above prior application. It was considered that there was a possibility that materials exhibiting ferromagnetism were contained in the impurities. Accordingly, further studies have been made. Namely, there was a possibility that a trace amount of a different phase from the La-Ba-Cu-O system was contained in the LaBa₂Cu₃O_{7-y} compound. This different phase, however, was not confirmed by X-ray diffraction pattern. Accordingly, the confirmation of the different phase in the micro-region and the identification of the ratio of elements in said phase were carried out in detail by using SEM and EPMA. The observation of structure of the micro-region was made by SEM, and the identification of the ratio of elements was made by EPMA.

It was found that BaCuO₂ (already confirmed by previous application) and La₄Ba₂Cu₂O₁₀ phases, in addition to the compound having a composition of LaBa₂Cu₃O_{7-y}, were present in the previously prepared LaBa₂Cu₃O_{7-y} compound.

In order to examine the phase which exhibited ferromagnetism, a sample was prepared under the same conditions as those for the preparation of the aforesaid LaBa₂Cu₃O_{7-y} compound exhibiting unusual magnetic properties. It was found that only La₄Ba₂Cu₂O₁₀ exhibited ferromagnetism and BaCuO₂ did not exhibit it.

There was prepared a LaBa₂Cu₃O_{7-y} compound containing a large amount of La₄Ba₂Cu₂O₁₀ intentionally formed by changing the calcining conditions (e.g., changing the sintering temperature in a reducing atmosphere) used for the preparation of the LaBa₂Cu₃O_{7-y} compound in the prior application. The compound was analyzed by X-ray diffraction to examine the relationship between the peak intensity of La₄Ba₂Cu₂O₁₀ and the magnitude of ferromagnetic susceptibility. There was a positive correlation between them.

Nevertheless, the peak of La₄Ba₂Cu₂O₁₀ was not detected by X-ray diffraction in the prior application. The most likely reasons why the peak was not detected is that (1) the phase is almost overlapped with the peak of BaCuO₂ and (2) the phase is hidden by background, because there is only a small amount of the phase.

Thus, it is clear from the above experiment that the La₄Ba₂Cu₂O₁₀ compound exhibits ferromagnetism and the ferromagnetic behavior of the LaBa₂Cu₃O_{7-y} compound prepared above is caused by a small amount of La₄Ba₂Cu₂O₁₀ contained therein.

### (2) Preparation of La₄₋₂ₓBa₂₊₂ₓCu₂₋ₓO₁₀₋₂ₓ compounds

La₂O₃ powder, BaO powder and CuO powder were mixed in stoichiometric amounts. Test No. 1 involved the compound in which x=0 and test No. 2 involved the compound in which x=0.25. The powders except for BaO powder had a purity of 99.9%. La₂O₃ powder is highly hydroscopic so the powder was preheated at 900°C for 10 hours before use.

A closed furnace was used, and the mixture was calcined (preliminary calcining) in a nitrogen atmosphere at 900°C for 10 hours. The calcined product was cooled and crushed into a fine powder through a sive with holes having a diameter of 45 »m. In test No. 2, the mixture was preliminarily calcined in air for 10 hours. The fine powder was molded under a pressure of 1.5×10⁸ Pa to prepare a disk-form sample of 15 mmφ × 1 mm (thickness).

As shown in Fig. 6, the temperature was raised to 940°C at a heating rate of 200°C/hr in a nitrogen atmosphere (nitrogen partial pressure: 1.17 to 1.20 kg/cm²) and the sample was finally calcined at 940°C for 10 hours. The temperature was then lowered to 300°C at a cooling rate of 60°C/hr. The cooling of from 940°C to 860°C was carried out in the aforesaid nitrogen atmosphere, and the subsequent cooling was carried out in an oxygen atmosphere (oxygen partial pressure: 1.17 to 1.20 kg/cm²). The resulting sintered product was annealed in a dried oxygen atmosphere at 300°C for 10 hours. The drying of oxygen was carried out by passing it through molecular sieves.

Even when the aforesaid nitrogen atmosphere for preliminary calcining and final calcining is changed to another atmosphere (vacuum atmosphere, oxidizing atmosphere), an equivalent single phase compound can be obtained.

The crystal structure and magnetic susceptibility of each sintered product and the element ratio of the micro-region were measured. The structure of the micro-region was observed. The crystal structure was measured by X-ray diffraction using monochromatized Cu-Kα rays. Magnetic susceptibility was measured by a SQUID magnet meter. Measured value was the average of three or more measurements.

### (3) Examination of crystal structure

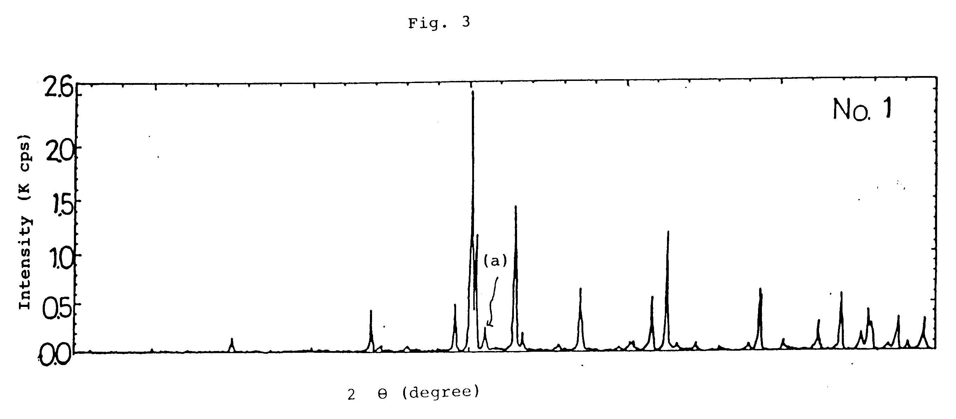

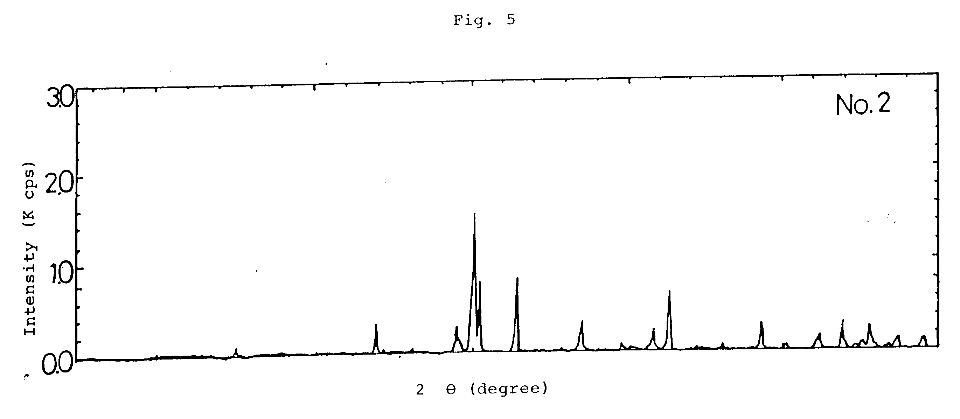

Fig. 3 shows an X-ray diffraction pattern of the sintered product No. 1 in which x=0. Fig. 5 shows an X-ray diffraction pattern of the sintered product No. 2 in which x=0.25. Both figures showed a single phase having a predetermined composition ratio, and did not show other different phases except that peak (a) in Fig. 3, was found. The assignment of peak (a) is not clear so far.

### (4) Examination of magnetic properties

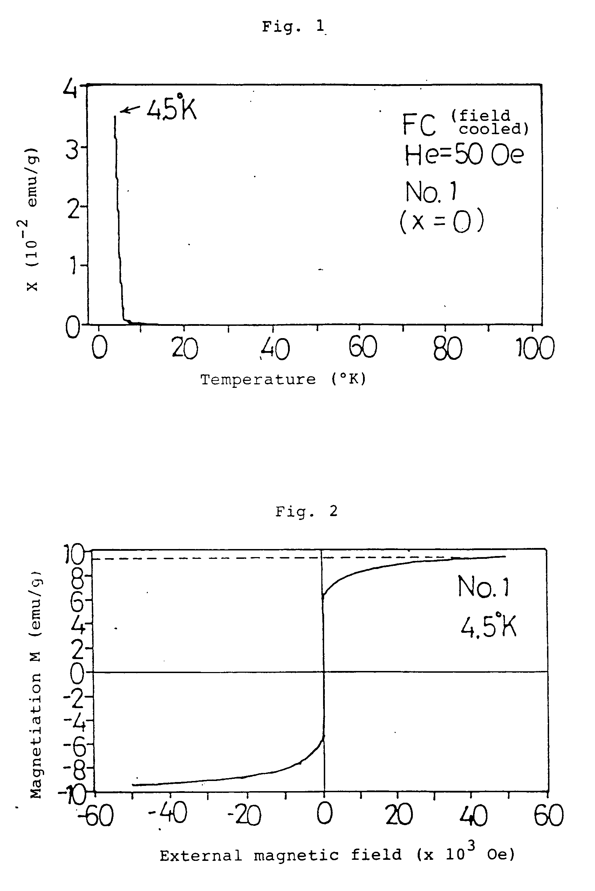

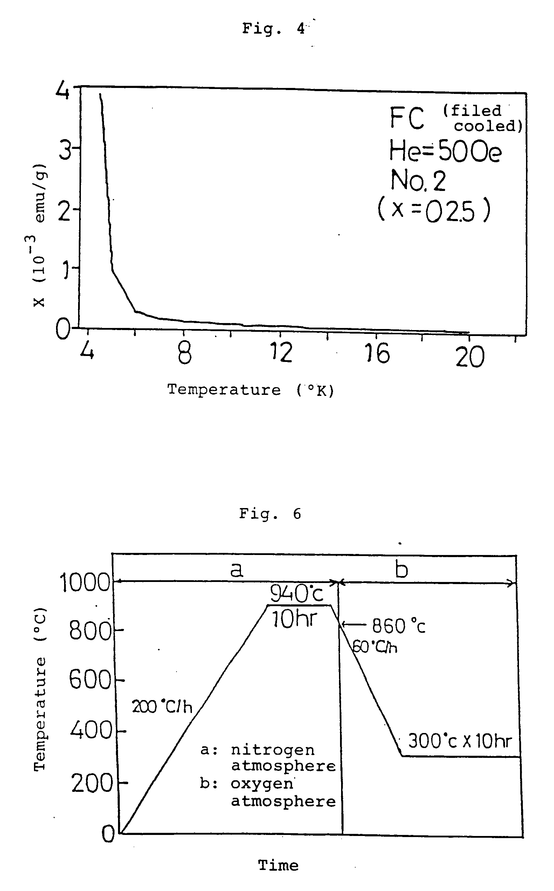

Fig. 1 shows the relationship between DC magnetic susceptibility X and temperature in the case where x=0 (No. 1). Fig. 4 shows the relationship in the case where x=0.25 (No. 2). Both show the results of the case (FC) where the samples were cooled while applying an external magnetic field of 50 Oe. The measurement was made at a temperature within the temperature range of 100K or below. In Fig. 1, the measured curve is overlapped with a base line (0 line) at a temperature of about 10 or 15K or higher, but the graph shown in Fig. 3 was obtained at 20K or below. Fig. 4 is a graph at 20K or below, however, when measurement is made at 100K or below, a graph shown in Fig. 1 is obtained.

In the former (x=0) case, positive divergence is caused at 6K or below and the magnitude thereof is about 10 times that of the aforesaid LaBa₂Cu₃O_{7-y} compound. As shown in Fig. 2, which shows the relationship at 4.5K between external magnetic field H and magnetization M, the curve rises suddenly at a magnetic field of 0. These results can be understood as indicating that the compound exhibits ferromagnetism at low temperatures. The effective magnetic moment determined from Curie-Weiss plots in terms of paramagnetic area is 1.66 »B/Cu. Saturation magnetization determined from hysteresis is 0.95 »B/Cu. These results can be understood as indicating that Cu²⁺ ions at spin 1/2 participate in localized-type ferromagnetism.

In the latter (x=0.25) case, positive divergence occurs at about 5 or 6K or below as shown in Fig. 4 and the compounds exhibits ferromagnetism. However, the magnitude thereof is as low as about 1/10 that of the former (x=0).

### (5) Other modification

The present invention is not limited to the above-described example, but it is obvious that there can be variations and modifications which can be made according to purpose and use without departing from the scope of the invention. For example, the starting materials are not limited to the above-described oxides, but other oxides can be used. Further, there can be used any materials which can be converted into oxides by heating. Finely divided oxides or materials are preferred. Preferably, crushing is carried out by using balls made of materials which do not allow impurities to be introduced.

Calcining may be one-step calcining or two-step calcining consisting of preliminary calcining (pre-calcining) and final calcining. Calcining temperature (including pre-calcining and final calcining) is set to a temperature within the predetermined range and generally 940 to 1000°C. The patterns of the temperature are not limited to those described above. Other heating rates and cooling rates can be used. The aforesaid calcining atmosphere and annealing (heat treatment) atmosphere are not limited to those described above. If desired, oxidizing atmosphere, vacuum atmosphere or reduction atmosphere may be used. Oxygen partial pressure in reduction atmosphere or oxidizing atmosphere can be arbitrarily set. Further, preliminary calcining temperature, calcining temperature and temperature at which atmosphere is changed, are not limited to those described above.

The La₄₋₂ₓBa₂₊₂ₓCu₂₋ₓO₁₀₋₂ₓ compounds of the present invention are known as ceramics copper compounds which have for the first time been found to exhibit ferromagnetism. Transition to ferromagnetism occurs at low temperature. Particularly, the La₄₋₂ₓBa₂₊₂ₓCu₂₋ₓO₁₀₋₂ₓ compound (where 0≦x<0.15) of the second embodiment according to the present invention are novel low-temperature ferromagnetic compounds. The compound where x=0 has remarkably large magnetic susceptibility in comparison with the compounds where x=0.25. Accordingly, when x is less than 0.15, ferromagnetism becomes greater and hence such compounds where x<0.15 are very useful. The compound where x=0 is considered to have the largest ferromagnetism and is still more useful.

Further, the compounds of the present invention are ceramics of copper oxides and can give sintered articles having desired shapes and ferromagnetism, as well as mechanical characteristics such as strength when the compounds are molded and sintered. Accordingly, the compounds of the present invention have a remarkable effect and are practical to use.

Further, the compounds of the present invention are compounds having a composition La-Ba-Cu-O so that superconductive compounds can also be prepared by changing the composition, and composite material can be prepared as disclosed in the aforesaid prior application, said composite material being a mixture of a ferromagnetic compound and a superconductive compound and having both performances. Accordingly, the compounds of the present invention have a variety of applications.

While the invention has been described in detail and with reference to specific embodiments thereof, it will be apparent to one skilled in the art that various changes and modifications can be made therein without departing from the scope thereof.

## Claims

1. A ferromagnetic La-Ba-Cu-O compound which has a composition of La₄₋₂ₓBa₂₊₂ₓCu₂₋ₓO₁₀₋₂ₓ, wherein 0≦x<0.15, and which exhibits ferromagnetism at low temperatures.

2. A ferromagnetic La-Ba-Cu-O compound as in claim 1, wherein 0≦x≦0.12.

3. A ferromagnetic La-Ba-Cu-O compound as in claim 2, wherein 0≦x≦0.10.

4. A millimetric wave heterodyne mixer which comprises a ferromagnetic La-Ba-Cu-O compound which has a composition of La₄₋₂ₓBa₂₊₂ₓCu₂₋ₓO₁₀₋₂ₓ wherein 0≦x≦0.25, and which exhibits ferromagnetism at low temperatures.

5. A millimetric wave heterodyne mixer as in claim 4 wherein 0≦x≦0.15.

## Patentansprüche

1. Ferromagnetische La-Ba-Cu-O-Verbindung, welche eine La₄₋₂ₓBA₂₊₂ₓCu₂₋ₓO₁₀₋₂ₓ-Zusammensetzung aufweist, wobei 0 ≦ x < 0,15, und welche bei niedrigen Temperaturen Ferromagnetismus aufweist.

2. Ferromagnetische La-Ba-Cu-O-Verbindung nach Anspruch 1, wobei 0 ≦ x ≦ 0,12.

3. Ferromagnetische La-Ba-Cu-O-Verbindung nach Anspruch 2, wobei 0 ≦ x ≦ 0,10.

4. Millimeterwellenüberlagerungsgerät, umfassend eine ferromagnetische LA-Ba-Cu-O-Verbindung, welche eine La₄₋₂ₓBa₂₊₂ₓCu₂₋ₓO₁₀₋₂ₓ-Zusammensetzung aufweist, wobei 0 ≦ x ≦ 0,25, und welche bei niedrigen Temperaturen Ferromagnetismus aufweist.

5. Millimeterwellenüberlagungsgerät nach Anspruch 4, wobei 0 ≦ x ≦ 0,15.

## Revendications

1. Composé La-Ba-Cu-O ferromagnétique qui a une composition de La₄₋₂ₓBa₂₊₂ₓCU₂₋ₓO₁₀₋₂ₓ, dans laquelle 0 ≦ x < 0,15, et qui présente le ferromagnétisme à basses températures.

2. Composé La-Ba-Cu-O ferromagnétique selon la revendication 1, dans lequel 0 ≦ x ≦ 0,12.

3. Composé La-Ba-Cu-O ferromagnétique selon la revendication 2, dans lequel 0 ≦ x ≦ 0,10.

4. Mélangeur hétérodyne d'ondes millimétriques qui comprend un composé La-Ba-Cu-O ferromagnétique qui a une composition de La₄₋₂ₓBa₂₊₂ₓCU₂₋ₓO₁₀₋₂ₓ dans laquelle 0 ≦ x ≦ 0,25, et qui présente le ferromagnétisme à basses températures.

5. Mélangeur hétérodyne d'ondes millimétriques selon la revendication 4, dans lequel 0 ≦ x ≦ 0,15.
